# EUROPEAN PATENT APPLICATION

(11) **EP 4 421 882 A1**
(43) Date of publication of application: **28.08.2024**
(21) Application number: 23822223.6
(22) Date of filing: 23.05.2023
(51) Int. Cl.: H01L 31/0224, H01L 31/042

(54) **SOLAR CELL STENCIL, SOLAR CELL, AND PHOTOVOLTAIC MODULE**

(30) Priority: 05.01.2023 CN 202320021230 U
(71) Applicant: Zhejiang Jinko Solar Co., Ltd., Haining, Zhejiang 314416 (CN); JINKO SOLAR CO., LTD, ShangRao, Jiangxi 334100 (CN)
(72) Inventor: TAO, Wusong, Jiaxing, Zhejiang 314416 (CN); FENG, Jun, Jiaxing, Zhejiang 314416 (CN); LUO, Heng, Jiaxing, Zhejiang 314416 (CN)
(74) Representative: Balder IP Law, S.L.
(86) International application number: PCT/CN2023/095899
(87) International publication number: WO 2024/146054

(57) **Abstract**

A solar cell screen plate, a solar cell, and a photovoltaic module are provided. The solar cell screen plate includes a plurality of parallel finger electrodes, where each respective finger electrode of the plurality of finger electrodes includes a plurality of disconnection portions; and a plurality of enhancement grid lines parallel to the plurality of finger electrodes, where each respective enhancement grid line is located at a respective disconnection portion, and the respective enhancement grid line has both ends each being in electrical contact with a part of a region of the respective finger electrode other than the plurality of disconnection portions, and where the respective enhancement grid line is in electrical contact with a respective solder strip. The respective enhancement grid line includes printing paste different from printing paste of the respective finger electrode.

## Description

### CROSS REFERENCE TO RELATED APPLICATIONS

This application claims priority to Chinese Patent Application No. CN202320021230.0, entitled "SOLAR CELL SCREEN PLATE AND SOLAR CELL," filed on January 5, 2023, which is hereby incorporated by reference in its entirety.

### TECHNICAL FIELD

The various embodiments described in this document relate in general to the technical field of photovoltaic cells, and more specifically to a solar cell screen plate, a solar cell, and a photovoltaic module.

### BACKGROUND

Solar cells are devices that directly convert light energy into electrical energy through photoelectric effect or photochemical effect. Individual cells are not directly used for power generation. A plurality of cells can be used only after being connected in series and/or in parallel through solder strips and then tightly encapsulated into modules. The solar cell module (also called solar panel) is the core part or the most important part of a solar power generation system. The solar cell module is used for converting solar energy into the electrical energy, and transferring the electrical energy to batteries for storage, or driving the load to work.

The cell is relatively fragile, so it is generally necessary to arrange adhesive films and cover plates on both upper and lower surfaces of the cell module to protect the solar cells. The cover plate is generally photovoltaic glass, and the photovoltaic glass is generally not directly attached on the cell. Therefore, there is a need to dispose the adhesive film between the cover plate and the solar cells to play a bonding role. The cells are generally connected through solder strips for collecting current, and conventional solder strips need to be alloyed between the solder strip and finger electrodes during welding. However, solder in the solder strip generally has a relatively high melting point temperature, and during welding, a welding temperature is higher than the melting point temperature of the solder by more than 20°C. Since large warpage deformation occurs in the cells during the welding, the cell has a relatively high risk of cracking and a high fragment rate after welding. Therefore, in order to improve the welding quality, low-temperature solder strip and technologies without the use of main busbars emerged. However, there are still many factors that affect the yield of modules, e.g., the welding effect and the welding yield between the solder strips and the finger electrodes.

### SUMMARY

Embodiments of the disclosure provide a solar cell screen plate, a solar cell, and a photovoltaic module.

According to an aspect, embodiments of the disclosure provide a solar cell screen plate, including: 16 parallel main busbars; a plurality of parallel finger electrodes perpendicular to the 16 main busbars, where each respective finger electrode of the plurality of finger electrodes includes a plurality of disconnection portions, and each disconnection portion is defined at an intersection between a respective main busbar of the 16 main busbars and the respective finger electrode; and a plurality of enhancement grid lines parallel to the plurality of finger electrodes, where each respective enhancement grid line is located at a respective disconnection portion, and the respective main busbar penetrates through the respective enhancement grid line.

According to another aspect, embodiments of the disclosure further provide a solar cell screen plate, including: a plurality of parallel finger electrodes, where each respective finger electrode of the plurality of finger electrodes includes a plurality of disconnection portions; and a plurality of enhancement grid lines parallel to the plurality of finger electrodes, where each respective enhancement grid line is located at a respective disconnection portion, and the respective enhancement grid line has both ends each being in electrical contact with a part of a region of the respective finger electrode other than the plurality of disconnection portions, and where the respective enhancement grid line is in electrical contact with a respective main busbar or configured to be in electrical contact with a respective solder strip. The respective enhancement grid line includes printing paste different from printing paste of the respective finger electrode.

According to yet another aspect, embodiments of the disclosure further provide a solar cell screen plate, including: a plurality of parallel finger electrodes, where each respective finger electrode of the plurality of finger electrodes includes a plurality of disconnection portions; and a plurality of enhancement grid lines parallel to the plurality of finger electrodes, where each respective enhancement grid line is located at a respective disconnection portion, and the respective enhancement grid line has both ends each being in electrical contact with a part of a region of the respective finger electrode other than the plurality of disconnection portions, and where the respective enhancement grid line is configured to be in electrical contact with a respective solder strip. The respective enhancement grid line includes printing paste different from printing paste of the respective finger electrode.

According to yet another aspect, embodiments of the disclosure further provide a solar cell, including the solar cell screen plate described in any embodiment of the disclosure.

According to yet another aspect, embodiments of the disclosure further provide a photovoltaic module, including a plurality of cell strings, where each cell string is formed by connecting a plurality of solar cells, and each solar cell is the solar cell described in any embodiment of the disclosure; a plurality of solder strips configured to connect the plurality of solar cells; an encapsulation film configured to cover a surface of each of the plurality of cell strings and a surface of each of the plurality of solder strips; and a plurality of cover plates, where each cover plate is configured to cover a surface of the encapsulation film away from the plurality of cell strings.

### BRIEF DESCRIPTION OF THE DRAWINGS

One or more embodiments are described as examples with reference to the corresponding figures in the accompanying drawings and the exemplary illustration does not constitute a limitation to the embodiments. Unless otherwise stated, the figures in the accompanying drawings do not constitute a proportion limitation. In order to more clearly explain that embodiments of the disclosure or technical solutions in the conventional technique, the drawings required for use in the embodiments will be briefly described below, and it will be apparent that the drawings described below are only some of the embodiments of the disclosure, from which other drawings may be obtained without creative effort by a person of ordinary skill in the art.
FIG. 1 is a schematic view of a solar cell screen plate according to embodiments.
FIG. 2 is a schematic view of a solar cell screen plate according to other embodiments.
FIG. 3 is a schematic view of a solder pad of the solar cell screen plate.
FIG. 4 is a schematic view of a solar cell.
FIG. 5 is a schematic top view of finger electrodes of a solar cell screen plate.
FIG. 6 is a schematic top view of enhancement grid lines of the solar cell screen plate.
FIG. 7 is a schematic top view of a solar cell screen plate according to a first embodiment.
FIG. 8 is a first schematic cross-sectional structural view of the solar cell screen plate along A1-A2 in FIG. 7.
FIG. 9 is a second schematic cross-sectional structural view of the solar cell screen plate along A1-A2 in FIG. 7.
FIG. 10 is a schematic top view of a solar cell screen plate according to a second embodiment.
FIG. 11 is a first schematic cross-sectional structural view of the solar cell screen plate along A1-A2 in FIG. 10.
FIG. 12 is a second schematic cross-sectional structural view of the solar cell screen plate along A1-A2 in FIG. 10.
FIG. 13 is a first schematic view of an enhancement grid line in the solar cell screen plate.
FIG. 14 is a second schematic view of an enhancement grid line in the solar cell screen plate.
FIG. 15 is a schematic structural view of a photovoltaic module.

### DETAILED DESCRIPTION OF THE EMBODIMENTS

Various exemplary embodiments of the present disclosure will now be described in detail with reference to the accompanying drawings. It is to be noted that the relative arrangement of the components and steps set forth, numeric expressions, and numerical values in these embodiments do not limit the scope of the disclosure unless otherwise specified.

The following description of at least one exemplary embodiment is in fact illustrative only and is in no way intended to limit the disclosure and application or use of the disclosure.

Techniques, methods, and devices known to those of ordinary skill in the relevant art may not be discussed in detail, but where appropriate, such techniques, methods, and devices should be regarded as part of the specification.

In all examples shown and discussed herein, any specific value shall be interpreted as illustrative only and not as a limitation. Therefore, other examples of exemplary embodiments may have different values.

It is to be noted that like numerals and letters denote like terms in the following drawings, and therefore, once an item is defined in one drawing, it does not need to be further discussed in subsequent drawings.

Various embodiments of the disclosure may be described in detail below with reference to the accompanying drawings. However, those of ordinary skill in the art should appreciate that many technical details have been proposed in various embodiments of the disclosure for better understanding of the disclosure. The technical solutions in the disclosure are able to be realized even without these technical details as well as various changes and modifications based on the following embodiments.

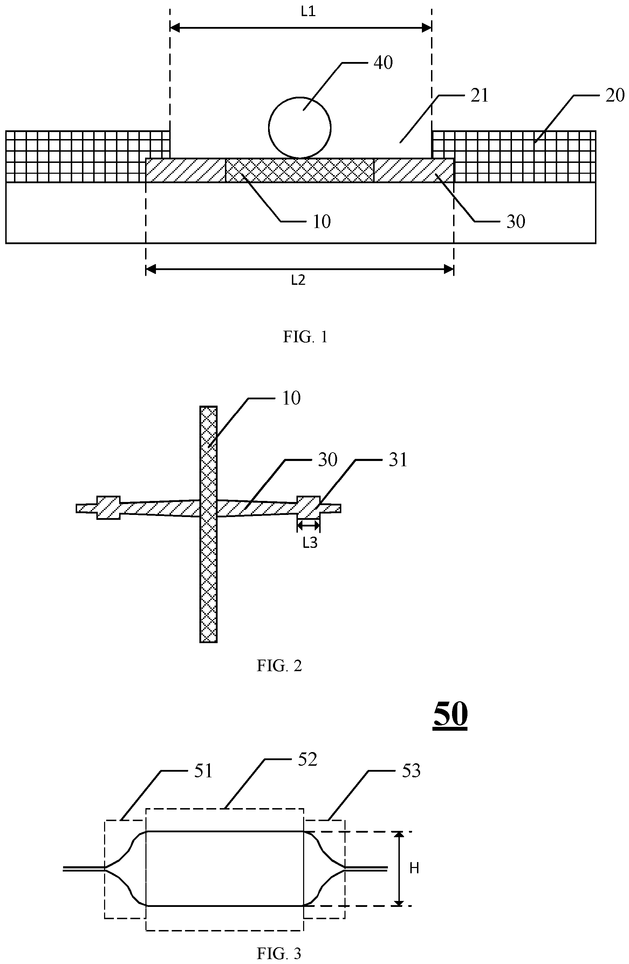

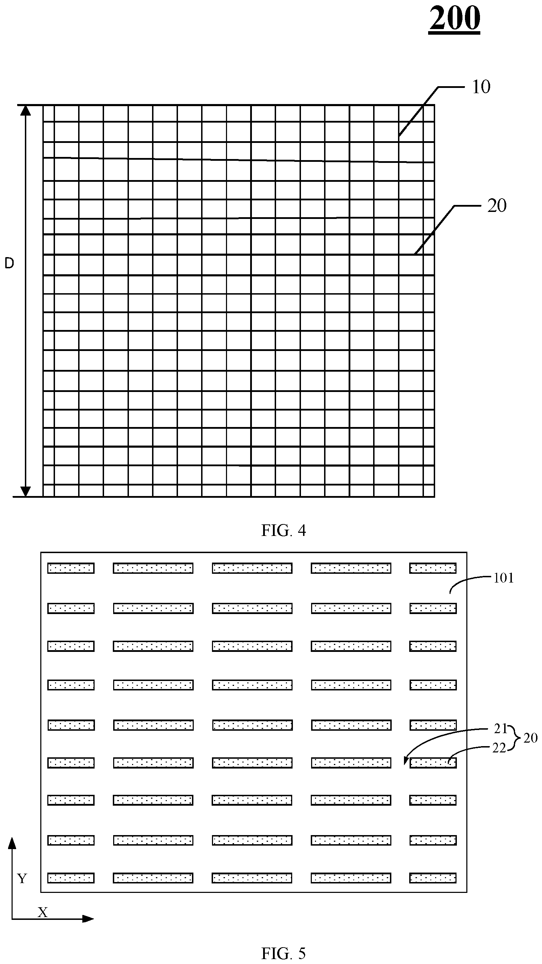

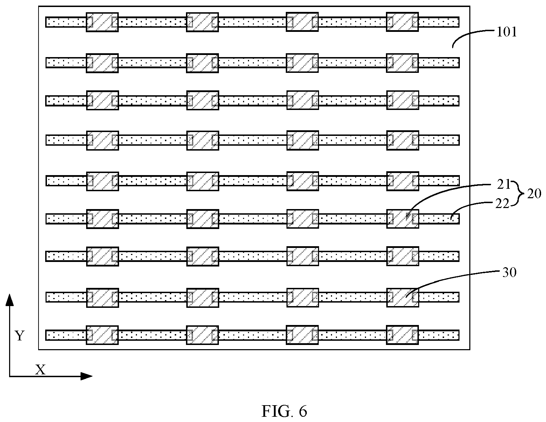

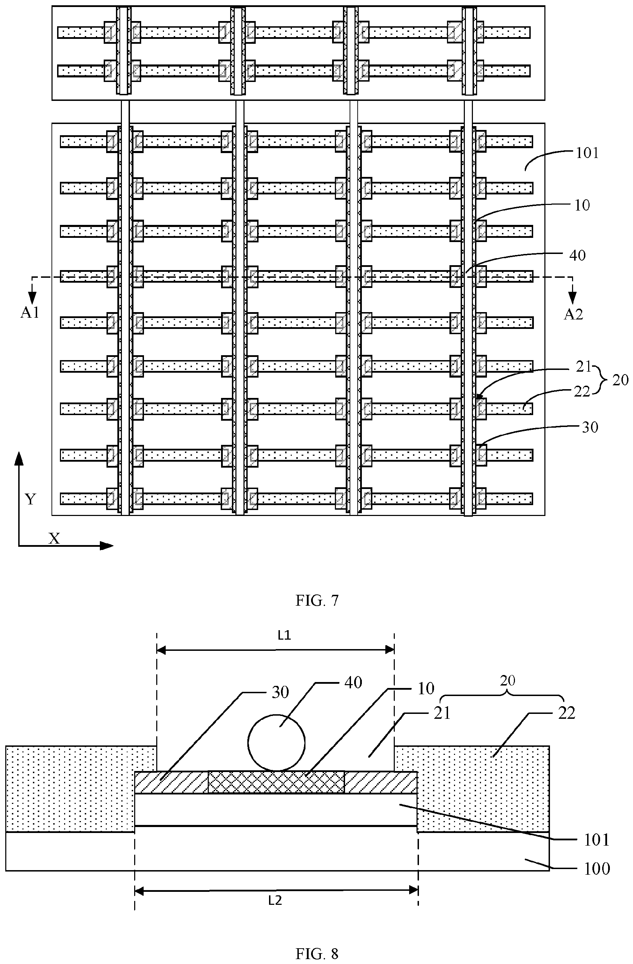

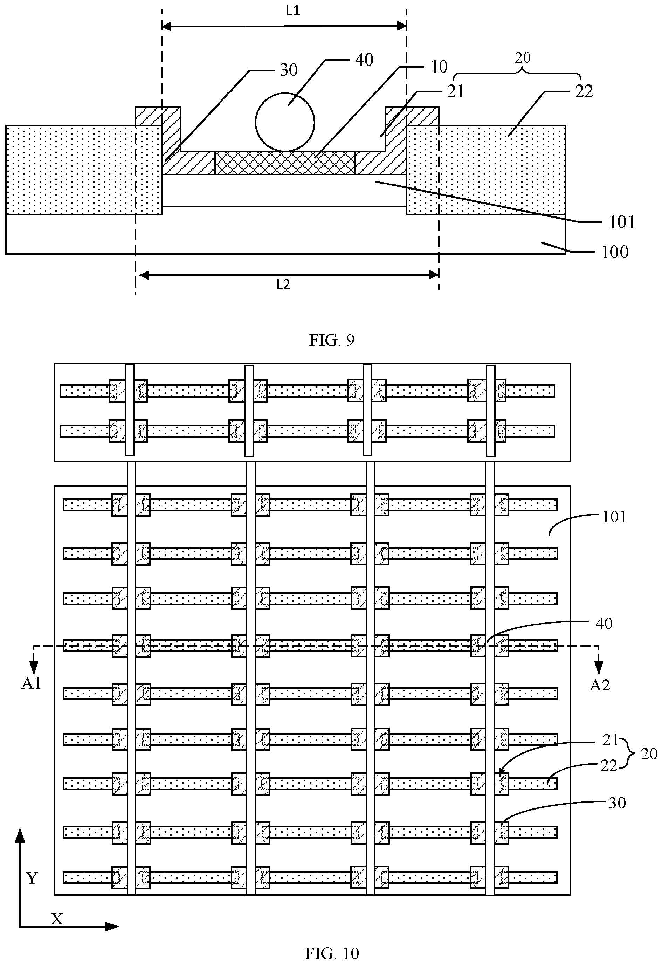

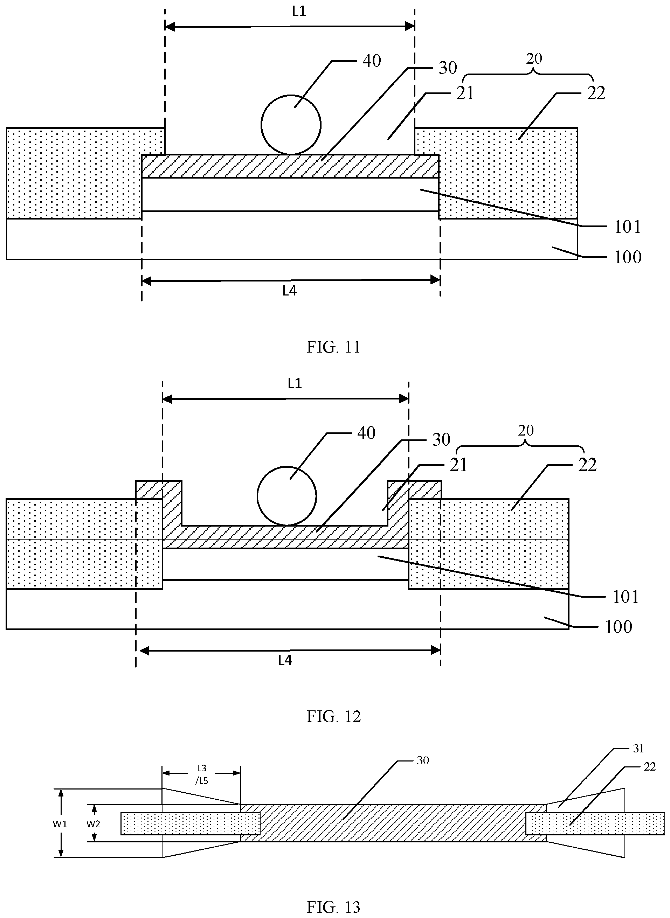

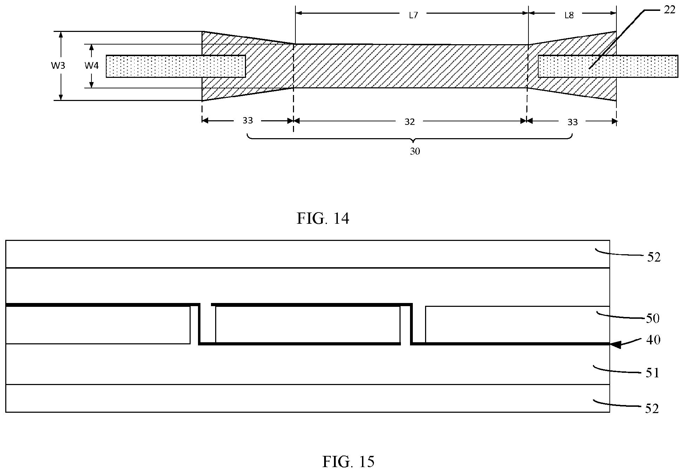

FIG. 1 is a schematic view of a solar cell screen plate according to embodiments. FIG. 2 is a schematic view of a solar cell screen plate according to other embodiments. FIG. 3 is a schematic view of a solder pad of the solar cell screen plate. FIG. 4 is a schematic view of a solar cell. FIG. 5 is a schematic top view of finger electrodes of a solar cell screen plate. FIG. 6 is a schematic top view of enhancement grid lines of the solar cell screen plate. FIG. 7 is a schematic top view of a solar cell screen plate according to a first embodiment. FIG. 8 is a first schematic cross-sectional structural view of the solar cell screen plate along A1-A2 in FIG. 7. FIG. 9 is a second schematic cross-sectional structural view of the solar cell screen plate along A1-A2 in FIG. 7. FIG. 10 is a schematic top view of a solar cell screen plate according to a second embodiment. FIG. 11 is a first schematic cross-sectional structural view of the solar cell screen plate along A1-A2 in FIG. 10. FIG. 12 is a second schematic cross-sectional structural view of the solar cell screen plate along A1-A2 in FIG. 10. FIG. 13 is a first schematic view of an enhancement grid line in the solar cell screen plate. FIG. 14 is a second schematic view of an enhancement grid line in the solar cell screen plate.

Referring to FIGS. 1 to 14, a solar cell screen plate includes a plurality of parallel secondary grid lines (finger electrodes) 20 and a plurality of enhancement grid lines 30. Each respective finger electrode 20 includes a plurality of disconnection portions 21. Each respective enhancement grid line 30 is located at a corresponding disconnection portion 21. The plurality of enhancement grid lines 30 are parallel to the plurality of finger electrodes 20. The respective enhancement grid line 30 has both ends each being in electrical contact with a part of a region of a corresponding finger electrode 20 except the plurality of disconnection portions 21. The respective enhancement grid line 30 is in electrical contact with a corresponding main grid line (main busbar) 10 or in electrical contact with a corresponding solder strip 40. Printing paste of the respective enhancement grid line 30 is different from printing paste of the corresponding finger electrode 20.

In some embodiments, the solar cell screen plate is part of a solar cell. The solar cell is any of conventional cells, such as an interdigitated back contact (IBC) cell, a tunnel oxide passivated contact (TOPCON) cell, a passivated emitter rear cell (PERC) cell, and a heterojunction cell, and the like. In some embodiments, the solar cell may also be a compound cell, and compounds of the compound cell include, but are not limited to, silicon germanium, silicon carbide, gallium arsenide, indium gallium, perovskite, cadmium telluride, copper indium selenium, and other materials.

The solar cell includes a substrate 100 and a passivation layer 101 that are stacked in sequence. A material of the substrate 100 may be an elemental semiconductor material. Specifically, the elemental semiconductor material includes a single element, which may be silicon for example. The elemental semiconductor material may be a monocrystalline state, a polycrystalline state, an amorphous state, or a microcrystalline state (a state having both a monocrystalline state and an amorphous state). For example, the silicon may be at least one of monocrystalline, polycrystalline silicon, amorphous silicon, or microcrystalline silicon.

In some embodiments, the material of the substrate 100 may also be a compound semiconductor material. The common compound semiconductor materials include, but are not limited to, silicon germanium, silicon carbide, gallium arsenide, indium gallium, perovskite, cadmium telluride, copper indium selenium, and other materials. The substrate 100 may also be a sapphire substrate, a silicon-on-insulator substrate, or a germanium-on-insulator substrate.

In some embodiments, the substrate 100 may be an N-type semiconductor substrate or a P-type semiconductor substrate. The N-type semiconductor substrate is doped with an N-type doping element, and the N-type doping element can be any one of Group V elements, such as phosphorus (P), bismuth (Bi), antimony (Sb), or arsenic (As). The P-type semiconductor substrate is doped with a P-type doping element, and the P-type doping element can be any one of Group III elements, such as boron (B), aluminum (Al), gallium (Ga), or gallium (In).

The substrate 100 includes a first side and a second side opposite to the first side. When the solar cell is not an IBC cell, the solar cell includes an emitter and a first passivation layer that are disposed on the first side of the substrate, and a second passivation layer on the second side of the substrate. Each first electrode penetrates through the first passivation layer to be in electrical contact with the emitter, and each second electrode penetrates through a thickness of the second passivation layer to be in electrical contact with the second side. In case where the passivation layer 101 is the first passivation layer, the finger electrodes 20 are first electrodes. In case where the passivation layer 101 is the second passivation layer, the finger electrodes 20 are second electrodes.

When the solar cell is an IBC cell, the solar cell includes a first passivation layer on the first side of the substrate 100, and first doped regions interleaved with second doped regions on the second side of the substrate. A second passivation layer is arranged on the first doped regions and the second doped regions. Each first electrode penetrates through the second passivation layer to be in electrical contact with a corresponding first doped region, and each second electrode penetrates through the second passivation layer to be in electrical contact with a corresponding second doped region. The passivation layer 101 is the second passivation layer, and the finger electrodes 20 are first electrodes or second electrodes.

In some embodiments, when the solar cell is a TOPCON cell, the solar cell may further include a tunneling dielectric layer and a doped conductive layer that are stacked. The tunneling dielectric layer is located on a surface of the substrate 100 and each finger electrode 20 burns through the passivation layer 101 to be in electrical contact with the doped conductive layer.

In some embodiments, a material of the passivation layer 101 includes any one or more of materials such as silicon oxide, silicon nitride, silicon oxynitride, silicon carbonitride, titanium oxide, hafnium oxide, or aluminum oxide.

In some embodiments, the finger electrodes 20 are secondary grid lines of the solar cell. The finger electrodes 20 may be sintered from burn-through pastes. The finger electrodes 20 are formed as follows. Metal pastes are printed on a part of a surface of the passivation layer by adopting a screen-printing process. The metal pastes may include at least one of silver, aluminum, copper, tin, gold, lead, or nickel. Thereafter, the metal pastes are subjected to a sintering process. In some embodiments, the metal pastes include a highly corrosive material such as glass, such that during the sintering, the corrosive material may corrode the passivation layer 101. Therefore, the metal pastes may penetrate through the passivation layer to be in electrical contact with the substrate 100.

In some embodiments, each finger electrode 20 includes a plurality of disconnection portions 21 and a plurality of first grid lines 22, where each of the plurality of disconnection portions 21 means that adjacent first grid lines 22 are spaced apart from each other, i.e., there are no metal pastes printed in a region between the adjacent first grid lines 22, so that discontinuities occur in the finger electrode 20.

In some embodiments, the solar cell is a main grid cell, i.e., the solar cell further includes a plurality of main busbars 10. Each main busbar 10 is used for being in electrical contact with a corresponding solder strip 40, thereby increasing welding performance between the solder strips 40 and the cell and improving the yield of the photovoltaic module. Composition of printing pastes for the plurality of main busbars 10 is different from that of printing pastes for the finger electrodes 20. In addition, the printing pastes of the main busbars 10 do not burn through the passivation layer 101, so that the main busbars 10 are not in electrical contact with the substrate. However, the printing pastes of the finger electrodes 20 burn through the passivation layer 101 in the sintering process, such that the finger electrodes 20 are in electrical contact with the substrate 100.

In some embodiments, each respective enhancement grid line 30 has both ends each being in electrical contact with a corresponding first grid line 22. When the solar cell is the main grid cell, the respective enhancement grid line 30 is in electrical contact with a corresponding main busbar 10 to increase welding performance between the main busbar 10 and the finger electrode 20. When the solar cell is a cell without main busbars, the respective enhancement grid line 30 is in electrical contact with a respective solder strip 40, thereby increasing welding performance between the cell and the respective solder strip 40.

In some embodiments, the respective solder strip 40 has a circular cross section shown in FIG. 11, the solder strip having the circular cross section is free of orientation problems and alignment problems, and is easier to mass produce. In some embodiments, the respective solder strip 40 may have a triangular cross section, a rectangular cross section, or have a cross section of any other shapes, to increase a contact area between the respective solder strip and the respective enhancement grid line and avoid offset of alignment between the respective solder strip 40 and the enhancement grid line.

In some embodiments, the respective solder strip 40 has a size in a range of 160µm to 300µm. There may be 12 to 30 solder strips disposed on a single cell. The respective solder strip 40 may have the size in a range of 160µm to 180µm, 181µm to 200µm, 201µm to 220µm, 221µm to 240µm, 241µm to 280µm, or 281µm to 300µm.

In some embodiments, printing paste of the enhancement grid lines 30 is different from the printing paste of the finger electrodes 20, and is the same as the printing paste of the main busbars 10. Each enhancement grid line 30 does not penetrate through the thickness of the passivation layer 101 and is in electrical contact with the first grid lines 22. In this way, there is a good contact performance between the respective enhancement grid line 30 and the corresponding solder strip 40. In addition, the enhancement grid line 30 does not need to burn through the passivation layer 101, so that time for the sintering process can be reduced to reduce thermal damage of the cell.

In some embodiments, in an extension direction X of the respective finger electrode 20, each side surface of the respective enhancement grid line 30 is in electrical contact with a part of a region of the respective finger electrode 20 other than the plurality of disconnection portions 21. That is, the side surface of the respective enhancement grid line 20 is in electrical contact with a side surface of a corresponding first grid line 22. In some embodiments, one of upper and lower top surfaces of the respective enhancement grid line 30 is in electrical contact with the corresponding first grid line 22 in a thickness direction of the respective finger electrode 20, thereby increasing the contact area between the first grid line 22 and the enhancement grid line 30, reducing misalignment between the first grid line 22 and the enhancement grid line 30 during overprinting, and further improving the yield of the cells.

In some embodiments, the respective enhancement grid line 30 has a length L in the extension direction X of the respective finger electrode 20, 0.05mm ≤ L ≤ 1.5mm. L may be L2 in FIGS. 1, 8, and 9 or L4 in FIGS. 11 and 12. When the solar cell is the main grid cell, the length of the respective enhancement grid line 30 ensures that during alignment between the main busbar 10 and the enhancement grid line 30, a region serving as an alignment reference is large, thereby improving the accuracy of alignment between the main busbars 10 and the finger electrodes 20, and further improving the connection performance between the main busbars 10 and the finger electrodes 20. The respective enhancement grid line 30 should not be too long, to avoid reducing the area of the cell to collect current and reducing the cell efficiency. Similarly, when the solar cell is a cell without main busbars, the length of the respective enhancement grid line 30 can ensure the alignment between the solder strip 40 and the enhancement grid line 30, i.e., ensure that a region of the cell in contact with the solder strip 40 is the enhancement grid line 30, thereby improving the contact area and contact performance between the cell and the solder strip 40. In this case, the respective enhancement grid line 30 should also not be too long, to avoid reducing the area of the cell to collect current and reducing the cell efficiency.

In some embodiments, referring to FIG. 13, the solar cell screen plate further includes auxiliary solder joints 31 located on both sides of enhancement grid lines 30. A part of each respective auxiliary solder joint 31 is overlapped with and in electrical contact with another part of the region of the respective finger electrode 20 other than the plurality of disconnection portions 21. The respective auxiliary solder joint 31 and the respective enhancement grid line 30 are integrally formed, and is also made of the printing pastes of the main busbars.

In some embodiments, the auxiliary solder joints 31 are used for improving the accuracy of alignment between the respective enhancement grid line 30 and the respective finger electrode 20, to avoid offset and misalignment between the respective finger electrode 20 and the respective enhancement grid line 30, thereby avoiding problems such as excessive contact resistance between the respective finger electrode 20 and the respective enhancement grid line 30 or breakage of the grid lines. The auxiliary solder joints 31 are further used for increasing the contact area between the respective enhancement grid line 30 and the respective finger electrode 20, thereby ensuring the connection performance between the respective enhancement grid line 30 and the respective finger electrode 20, such that the welding performance between the solder strip 40 and the cell can be ensured and desoldering between the solder strip 40 and the cell can be avoided.

In some embodiments, in the thickness direction of the respective finger electrode 20, the another part of the region of the respective finger electrode 20 other than the plurality of disconnection portions 21 is in electrical contact with a part of a top surface of a corresponding auxiliary solder joint 31. Alternatively, in the thickness direction of the respective finger electrode 20, the another part of the region of the respective finger electrode 20 other than the plurality of disconnection portions 21 is in electrical contact with a part of a bottom surface of a corresponding auxiliary solder joint 31. In other words, in the thickness direction of the respective finger electrode 20, each first grid line 22 is in electrical contact with the part of the top surface of the corresponding auxiliary solder joint 31. Alternatively, in the thickness direction of the respective finger electrode 20, the first grid line 22 is in electrical contact with the part of the bottom surface of the corresponding auxiliary solder joint 31. Compared with the manner in which the side surface of each first grid line 22 is in electrical contact with a side surface of the corresponding auxiliary solder joint 31 in the extension direction X of the respective finger electrode 20, in embodiments of the disclosure, the contact area between the respective auxiliary solder joint 31 and the respective first grid line 22 is increased, thereby reducing the contact resistance between the first grid line 22 and the auxiliary solder joint 31 and further improving the cell efficiency.

In some embodiments, the respective auxiliary solder joint 31 has a width larger than a width of the respective finger electrode 20 in an arrangement direction Y of the finger electrodes 20. Since the width of each auxiliary solder joint 31 is large, when the auxiliary solder joints 31 are printed and then the finger electrodes 20 are overprinted, the relatively wider auxiliary solder joint 31 can ensure that the allowable offset range between each finger electrode 20 and the corresponding enhancement grid line 30 is relatively large, thereby improving the yield of the cells.

It is to be noted that the width of the respective auxiliary solder joint 31 is larger than the width of the respective finger electrode 20, but the width of the respective auxiliary solder joint 31 should not be too large, to reduce a shielding area of the solar cell and improve the cell efficiency.

In some embodiments, the respective auxiliary solder joint 31 may have a square shape as shown in FIG. 3 or a trapezoidal shape as shown in FIG. 13. There is no restriction on the shape of the respective auxiliary solder joint, as long as the width of the respective auxiliary solder joint is ensured to be larger than the width of the respective finger electrode.

In some embodiments, a length L3 of the respective auxiliary solder joint 31 in the extension direction X of the respective finger electrode ranges from 0.05mm to 1.5mm, i.e., 0.05mm ≤ L3 ≤ 1.5mm. The length L3 of the respective auxiliary solder joint 31 can ensure the contact area between each first grid line 22 and the respective auxiliary solder joint 31.

In some embodiments, the part of the respective auxiliary solder joint 31 overlapped with the another part of the region of the respective finger electrode 20 other than the plurality of disconnection portions 21 has a length of L5, 0.05mm ≤ L5 ≤1.5mm. That is, a length of an overlapping region between the respective auxiliary solder joint 31 and the first grid line 22 is L5. Since the respective enhancement grid line 30 is also in electrical contact with the respective first grid line 22, the length L5 shown in FIG. 13 is equal to the length L3 of the respective auxiliary solder joint 31 in the extension direction X of the respective finger electrode 20.

In some embodiments, in the arrangement direction Y of the finger electrodes 20, a side surface of the respective auxiliary solder joint 31 away from the corresponding enhancement grid line 30 has a first width W1, and another side surface of the respective auxiliary solder joint 31 in contact with the corresponding enhancement grid line 30 has a second width W2, where the first width W1 is larger than the second width W2. Therefore, during overprinting of the finger electrodes, the respective auxiliary solder joint 31 of the larger first width W1 can ensure that the allowable offset between each finger electrode 20 and the corresponding enhancement grid line 30 is large, thereby improving the yield of the cells. In addition, a difference value between the first width W1 and the second width W2 enables the side surface of the respective auxiliary solder joint 31 in the arrangement direction Y of the finger electrodes 20 to be served as a guide groove, thereby reducing the shielding area of the respective auxiliary solder joint 31 and improving a success rate of alignment between the respective finger electrode 20 and the enhancement grid line 30.

In some embodiments, the first width W1 is in a range of 0.02mm to 1.5mm, i.e., 0.02mm ≤ W1 ≤ 1.5mm. The first width W1 may range from 0.02mm to 0.8mm, 0.18mm to 1.39mm, 0.2mm to 1.5mm, 0.9mm to 1.48mm, 0.5mm to 1mm, 0.6mm to 1.3mm, or 0.09mm to 0.8mm. The first width W1 may be 0.06mm, 0.58mm, 0.77mm, 0.98mm, 1.19mm, 1.28mm, 1.33mm, 1.42mm, or 1.5mm.

The second width W2 is in a range of 0.02mm to 2mm, i.e., 0.02mm ≤ W2 ≤ 2mm. The second width W2 may range from 0.02mm to 1.21mm, 0.18mm to 1.68mm, 0.2mm to 1.97mm, 0.9mm to 1.59mm, 0.5mm to 1.31mm, 0.6mm to 1.38mm, or 0.09mm to 0.94mm. The second width W2 may be 0.06mm, 0.78mm, 1.22mm, 1.58mm, 1.67mm, 1.78mm, 1.87mm, 1.92mm, or 2mm.

In some embodiments, referring to FIG. 14, the respective enhancement grid line 30 includes first portions 33 and a second portion 32 connected between the first portions 33 in the extension direction X of the respective finger electrode 20. Each first portion 33 is in contact with the corresponding first grid line 22, and the second portion 32 is configured to be in contact with the corresponding solder strip 40 or the corresponding main busbar 10. An end surface of each first portion 33 away from the second portion 32 has a third width W3 larger than a fourth width W4 of a contact surface of the first portion 33 in contact with the second portion 32. During overprinting of the finger electrodes 20, the first portion 33 with the larger third width W3 can ensure that the allowable offset range between each finger electrode 20 and the corresponding enhancement grid line 30 is relatively large, thereby improving the yield of the cells. In addition, a difference value between the third width W3 and the fourth width W4 enables the side surface of the first portion 33 in the arrangement direction Y of the finger electrodes 20 to be served as a guide groove, thereby reducing the shielding area of the respective enhancement grid line 30 and improving the success rate of alignment between the respective finger electrodes 20 and the respective enhancement grid line 30.

In some embodiments, the second portion 32 has a length L7 ranging from 0.01mm to 1.5mm, i.e., 0.01mm ≤ L7 ≤ 1.5mm. The length L7 may range from 0.01mm to 0.17mm, 0.18mm to 1.31mm, 0.23mm to 1.5mm, 0.88mm to 1.48mm, 0.5mm to 1.1mm, 0.6mm to 1.27mm, or 0.09mm to 0.92mm. The length L7 can be 0.01mm, 0.29mm, 0.38mm, 0.76mm, 1.02mm, 1.16mm, 1.29mm, 1.41mm, or 1.5mm.

In some embodiments, each first portion 33 has a length L8 ranging from 0.05mm to 1.5mm, i.e., 0.05mm≤L8≤1.5mm. The length L8 may range from 0.06mm to 0.17mm, 0.2mm to 1.38mm, 0.25mm to 1.48mm, 0.93mm to 1.42mm, 0.46mm to 1.12mm, 0.7mm to 1.8mm, or 0.14mm to 1.45mm. The length L8 can be 0.05mm, 0.28mm, 0.41mm, 0.86mm, 1.08mm, 1.14mm, 1.24mm, 1.43mm, or 1.5mm.

In some embodiments, the third width W3 has a range of 0.02mm to 1.5mm, i.e., 0.02mm ≤ W3 ≤ 1.5mm. The third width W3 may range from 0.02mm to 0.8mm, 0.18mm to 1.39mm, 0.2mm to 1.5mm, 0.9mm to 1.48mm, 0.5mm to 1mm, 0.6mm to 1.3mm, or 0.09mm to 0.8mm. The third width W3 may be 0.06mm, 0.58mm, 0.77mm, 0.98mm, 1.19mm, 1.28mm, 1.33mm, 1.42mm, or 1.5mm.

The fourth width W4 has a range of 0.02mm to 2mm, i.e., 0.02mm ≤ W4 ≤ 2mm. The fourth width W4 may range from 0.02mm to 1.21mm, 0.18mm to 1.68mm, 0.2mm to 1.97mm, 0.9mm to 1.59mm, 0.5mm to 1.31mm, 0.6mm to 1.38mm, or 0.09mm to 0.94mm. The fourth width W4 may be 0.06mm, 0.78mm, 1.22mm, 1.58mm, 1.67mm, 1.78mm, 1.87mm, 1.92mm, or 2mm.

The following may describe embodiments of the soler cell being a main grid cell or a cell without main busbars with reference to the accompanying drawings.

For the solar cell being the main grid cell, in the photovoltaic industry, the conventional half-piece modules are generally connected through welding of solder strips on the cells. With the development of the cells, multi-busbars (MBB) and double-sided cell technologies in the cell design have become the mainstream technologies of crystalline silicon cells. The contact between the solder strips and main busbars becomes more important with the development of super MBB (SMBB) technology. Compared with the original cell having 9 main busbars (9BB), in the cell having 16 main busbars (16BB), the shading area may be reduced and the cell collection capacity may be improved by increasing the number of the main busbars, narrowing the individual main busbar, and optimizing the design of solder joints, such that the cell conversion efficiency can be improved by more than 0.3% and the unit consumption of silver paste can be reduced by more than 10mg. However, the increase in the number of the main busbars also brings challenges to the improvement of the welding effect of solder strips. Since the respective main busbar and the respective finger electrode have different heights, there may be a false welding problem caused by protruding of the solder strip at the junction between the respective main busbar and the respective finger electrode.

In view of this, embodiments of the disclosure provide a solar cell screen plate and a solar cell, which can improve false welding of the solder strips.

Referring to FIG. 1, embodiments of the disclosure provide a solar cell screen plate 100. The solar cell screen plate includes 16 parallel main busbars 10, a plurality of parallel finger electrodes 20, and a plurality of enhancement grid lines 30. The finger electrodes 20 are perpendicular to the main busbars 10. Each respective finger electrode 20 includes a plurality of disconnection portions 21, each disconnection portion is defined at an intersection between a respective one of the 16 main busbars 10 and the respective finger electrode 20. Each enhancement grid line 30 is disposed at a corresponding disconnection portion 21. The plurality of enhancement grid lines 30 are parallel to the plurality of finger electrodes 20. Each respective main busbar 10 penetrates through corresponding enhancement grid lines 30.

Specifically, in the solar cell, the finger electrodes 20 are arranged over the whole solar cell and are responsible for collecting the currents generated by photoelectric effect. The main busbars 10 are responsible for linking the finger electrodes 20 to transfer the currents. The currents are conducted into a loop through the solder strips 40 welded on the main busbars 10. The solar cell screen plate 100 includes the 16 main grid lines 10 parallel to one another and the plurality of finger electrodes 20 parallel to one another and perpendicular to the main busbars 10. Each two adjacent main busbars 10 are spaced apart from each other by 10.8mm and each two adjacent finger electrodes 20 are spaced apart from each other by 1.4mm to 1.6mm. The respective finger electrode 20 includes the plurality of disconnection portions 21. Each disconnection portion 21 is located at an intersection of the corresponding main busbar 10 and the respective finger electrode 20, and is provided with the corresponding enhancement grid line 30. The corresponding enhancement grid line 30 is parallel to the respective finger electrode 20. Each main busbar 10 penetrates through the corresponding enhancement grid lines 30. In this way, false welding caused by the protrusion of the solder strip 40 at the junction between the main busbar 10 and the finger electrode 20 due to the height difference between the finger electrode 20 and the main busbar 10 can be avoided. In addition, the respective finger electrode 20 includes the plurality of disconnection portions 21 and the plurality of first grid lines 22, which also reduces the paste consumption of the finger electrode 20 and reduces manufacturing costs.

In an alternative embodiment, the solar cell screen plate 100 includes the 16 main busbars and 116 finger electrodes.

It shall be understood that during step-by-step printing of the solar cell, printing paste of the main busbars 10 is different from printing paste of the finger electrodes 20, where a solid content in paste of the main busbars 10 is lower, so a height of each respective main busbar 10 is lower than that of a corresponding finger electrode 20. However, a height difference between the respective main busbar 10 and the corresponding finger electrode 20 may cause the solder strip 40 to be overhead at the junction of the respective main busbar 10 and the corresponding finger electrode 20, thus causing the false welding of the solder strip 40. In embodiments of the disclosure, the false welding of the solder strips 40 at the junction of the main busbars 10 and the finger electrodes 20 can be avoided by arranging the plurality of disconnection portions 21 and the plurality of enhancement grid lines 30. The main components of the paste of the main busbars 10 are: silver powder, aluminum powder, glass powder, organic carrier, and additives. The main compositions of the paste of the finger electrodes 20 are the same as that of the paste of the main busbars 10, but a proportion of a corresponding component of the paste of the finger electrodes 20 is different from a proportion of the corresponding component of the paste of the main busbars 10. For example, the proportion of silver powder of the paste of the finger electrode 20 is decreased, and the content of the aluminum powder and the glass powder is increased.

With continued reference to FIG. 1, in an alternative embodiment of the present disclosure, a length of each disconnection portion 21 in the extension direction of the respective finger electrode 20 is L1, where 0.3mm ≤ L1 ≤ 1.2mm.

Specifically, when the length L1 of each disconnection portion 21 in the extension direction of the respective finger electrode 20 is less than 0.3mm (L1<0.3mm), no sufficient regions are reserved for the main busbars 10 and the enhancement grid lines 30, and the false welding at the junction of the main busbars 10 and the finger electrodes 20 may still not be improved. When the length L1 of each disconnection section 21 in the extension direction of the respective finger electrode 20 is greater than 1.2mm, adjacent first grid lines are spaced apart from each other by a relatively large distance, which may affect the collection of the current generated by the photoelectric effect by the finger electrodes 20. When the length of the disconnection portion 21 in the extension direction of the respective finger electrode 20 is greater than or equal to 0.3mm and less than or equal to 1.2mm (0.3mm ≤ L1 ≤ 1.2mm), false welding at the junction of the main busbars 10 and the finger electrodes 20 can be improved, and the influence of the arrangement of the disconnection portions 21 on the finger electrodes 20 can be avoided to the greatest extent.

In an alternative embodiment of the disclosure, L1=0.4mm. In another alternative embodiment of the disclosure, L1=0.7mm. In yet another alternative embodiment of the disclosure, L1=1.2mm. In yet another alternative embodiment of the disclosure, 0.4mm ≤ L1 ≤ 0.8mm. In still yet another alternative embodiment of the disclosure, 0.6mm ≤ L1 ≤ 1.2mm.

With continued reference to FIG. 2, in an alternative embodiment of the disclosure, a length of each enhancement grid line 30 in the extension direction of the respective finger electrode 20 is L2, where 0.5mm ≤ L2 ≤ 1.5mm.

Specifically, each enhancement grid line 30 is located at the corresponding disconnection portion 21 and parallel to the respective finger electrode 20, and the respective main busbar penetrates through the corresponding enhancement grid line 30. The length L2 of each enhancement grid line 30 in the extension direction of the respective finger electrode 20 is slightly longer than the length L1 of the corresponding disconnection portion 21 in the extension direction of the respective finger electrode 20, so that connection between the respective finger electrode 20 and the respective main busbar 10 can be ensured, and the false welding caused by the overhead of the solder strip 40 can be avoided.

In an alternative embodiment of the disclosure, L2=0.5mm. In another alternative embodiment of the disclosure, L2=0.8mm. In yet another alternative embodiment of the disclosure, L2=1.4mm. In yet another alternative embodiment of the disclosure, 0.5mm ≤ L2 ≤ 1.0mm. In still yet alternative embodiment of the disclosure, 0.8mm ≤ L2 ≤ 1.5mm.

Continuing with reference to FIG. 1, in an alternative embodiment of the disclosure, the enhancement grid lines 30 are printed integrally with the main busbars 10 using same pastes.

Specifically, during printing of the main busbars 10, the enhancement grid lines 30 are printed integrally with the main busbars by using the paste of the main busbars 10, so that there are no finger electrodes between the main busbar and the enhancement grid line, and the false welding caused by the overhead of the solder strips 40 can be effectively solved. The main busbars 10 and the enhancement grid lines 30 are printed integrally using the same paste, so that no additional printing paste is needed in the manufacturing process, and the production is convenient.

Referring to FIGS. 1 and 2, in an alternative embodiment of the disclosure, the solar cell screen plate further includes auxiliary solder joints 31 located on both sides of each of the plurality of enhancement grid lines 30.

Specifically, auxiliary solder joints 31 are provided on both sides of the respective enhancement grid line 30, and each auxiliary solder joints 31 is spaced by 0.4mm to 0.5mm from the respective main busbar. It shall be understood that since a width of each edge of the respective enhancement grid line 30 is relatively small, misalignment of overprinting between the respective main busbar 10 and the respective finger electrode 20 is caused. That is, the respective main busbar 10 and the respective finger electrode 20 are not connected, and the overprinting accuracy cannot reach 18µm of the most edge on each of both sides of the respective enhancement grid line 30. Therefore, with aid of the auxiliary solder joints 31, an allowable range between the respective main busbar and the respective finger electrode 20 can be expanded to 30µm.

In an alternative embodiment of the disclosure, auxiliary solder joints 31 are arranged on both sides of the respective enhancement grid line 30 and each auxiliary solder joint 31 is spaced by 0.435mm from the respective main busbar.

With continued reference to FIG. 2, in an alternative embodiment of the disclosure, each auxiliary solder joint 31 is a square auxiliary solder joint with a side length of L3, where 0.02mm ≤ L3 ≤ 0.04mm.

Specifically, the square auxiliary solder joints 31 are arranged on both sides of the respective enhancement grid line 30 to improve the misalignment of overprinting of the respective main busbar 10 and the respective finger electrode 20. The side length of the respective square auxiliary solder joint 31 is L3, where 0.02mm ≤ L3 ≤ 0.04mm. In an alternative embodiment of the disclosure, L3 = 0.03mm. In another alternative embodiment of the disclosure, L3=0.02mm. In yet another alternative embodiment of the disclosure, L3=0.04mm.

Referring to FIG. 3, in an alternative embodiment of the disclosure, the solar cell screen plate further includes solder joints 50, where each solder joint 50 is in a shape of an irregular pattern formed by a first triangle 51, a first rectangle 52, and a second triangle 53 that are in communication with one another in an extension direction of the respective main busbar 10, and a junction between the first triangle 51, the first rectangle 52, and the second triangle 53 is arc-shaped.

The respective solder joint 50 has an irregular shape. Specifically, the respective solder joint 50 is an irregular solder joint composed of the first triangle 51, the first rectangle 52, and the second triangle 53 that run through with each other in the extension direction of the respective main busbar 10. The intersection between the first triangle 51, the first rectangle 52, and the second triangle 53 is designed with a chamfered arc shape, which can avoid detachment of the corners of the solder joint 50 due to the stress generated by the cold and hot transformation of the solder joint 50 concentrated on the corners of solder joint 50 during thermal cycling reliability testing, thereby avoiding increasing the power attenuation of the module.

With continued reference to FIG. 3, in an alternative embodiment of the present disclosure, a height of the respective solder joint 50 in a width direction of the respective main busbar 10 is H, where 0.3mm ≤ H ≤ 0.5mm.

Specifically, by setting the height H of the respective solder joint 50 in the width direction of the respective main busbar 10 to be greater than or equal to 0.3mm and less than or equal to 0.5mm, the area of the respective solder joint 50 is reduced, the material required for fabricating the respective solder joint 50 is saved, and the production cost is reduced. In an alternative embodiment of the disclosure, H=0.3mm. In another alternative embodiment of the disclosure, H=0.4mm. In yet another alternative embodiment of the disclosure, H=0.5mm. In still yet another alternative embodiment of the disclosure, 0.3mm ≤ H ≤ 0.4mm. In still yet another alternative embodiment, 0.4mm ≤ H ≤ 0.5mm.

Referring to FIG. 4, based on a same inventive concept, embodiments of the disclosure provide a solar cell, including the solar cell screen plate provided in any of the above embodiments.

In an alternative embodiment of the disclosure, the solar cell is a square solder cell with a side length of D, where D= 182mm. The side length D of the solar cell is 182mm, and the number of the main busbars 10 is 16.

Referring to FIGS. 1-4 or FIGS. 7-9, in an alternative embodiment of the disclosure, the side length D of the solar cell is equal to 182mm. The solar cell includes 16 main busbars 10 parallel to each other and 132 finger electrodes 20 parallel to each other. The finger electrodes 20 are perpendicular to the main busbars 10. Each two adjacent main busbars 10 are spaced apart from each other by 10.8mm, and each two adjacent finger electrodes 20 are spaced apart from each other by 1.5mm. At the junction of the respective main busbar 10 and the respective finger electrode 20, the respective finger electrode 20 is disconnected on both sides of the respective main busbar 10, to form a corresponding disconnection portion 21. The length L1 of the respective disconnection portion 21 in the extension direction of the respective finger electrode 20 is equal to 0.7117mm. The enhancement grid lines 30 are printed during printing of the main busbars 10 and the enhancement grid lines 30 and the main busbars 10 are integrally printed using the same printing paste. Therefore, all regions where the solder strip 40 will be welded are printed with the paste of the main busbars 10, without crossing of the finger electrodes 20, which can effectively solve the problem of false welding caused by the overhead of the solder strips 40. In addition, the square auxiliary solder joints 31 are provided on both sides of the respective enhancement grid line 30, where each auxiliary solder joint 31 is at a position spaced apart by 0.435mm from the respective main busbar, and the side length L3 of the respective auxiliary solder joint 31 is equal to 0.03mm, which can improve the misalignment of overprinting between the respective main busbar 10 and the corresponding finger electrode 20. Furthermore, each solder joint 50 is designed in an irregular shape. For example, each solder joint 50 is shaped in an irregular pattern formed by the first triangle 51, the first rectangle 52, and the second triangle 53 which are in communication with each other in the extension direction of the respective main busbar 10. The junctions between the first triangle 51, the first rectangle 52, and the second triangle 53 are arc-shaped, which can avoid detachment of the corners of the solder joint 50 due to the stress generated by the cold and hot transformation of the solder joint 50 concentrated on the corners of solder joint 50 during thermal cycling reliability testing, thereby avoiding increasing the power attenuation of the module. In addition, the height H of the respective solder joint 50 in the width direction of the respective main busbar 10 is set to be greater than or equal to 0.3mm and less than or equal to 0.5mm, thereby reducing the area of the respective solder joint 50, saving the material required for fabricating the respective solder joint 50, and reducing the production cost.

It is to be noted that the number and spacing of the main busbars 10 and the finger electrodes 20 in the drawings do not represent the actual number and spacing and are only used for illustration.

According to the above embodiments, the solar cell screen plate and the solar cell provided in the embodiments of the disclosure achieve at least the following beneficial effects.

According to the solar cell screen plate and the solar cell, the solar cell screen plate includes 16 parallel main busbars, and the plurality of parallel finger electrodes, and the plurality of enhancement grid lines. The finger electrodes are perpendicular to the main busbars. Each finger electrode includes the plurality of disconnection portions each located at the intersection of the respective main busbar and the respective finger electrode. Each enhancement grid line is located at the corresponding disconnection portion, and the enhancement grid lines are parallel to the finger electrodes. Each main busbar penetrates through the corresponding enhancement grid lines. The solar cell includes the solar cell screen plate. With this arrangement, the false welding caused by the protrusion of the solder strip at the junction of the main busbar and the finger electrode due to the height difference between the finger electrode and the main busbar is solved. Furthermore, each finger electrode includes the plurality of disconnection portions, which also reduces the consumption of the paste of the finger electrodes and reduces the manufacturing cost.

For the solar cell being a cell without main busbars, a solar cell screen plate includes a plurality of parallel finger electrodes 20, each finger electrode 20 including a plurality of disconnection portions 21; and a plurality of enhancement grid lines 30. Each of the plurality of enhancement grid lines 30 is located at a corresponding disconnection portion 21. The plurality of enhancement grid lines 30 are parallel to the plurality of finger electrodes 20. Each respective enhancement grid line 30 has both ends each being in electrical contact with a part of a region of the corresponding finger electrode 20 except the plurality of disconnection portions 21. The respective enhancement grid line 30 is in electrical contact with a corresponding solder strip 40. The printing paste of the respective enhancement grid line 30 is different from the printing paste of the corresponding finger electrode 20.

In some embodiments, in the arrangement direction Y of the finger electrodes 20, a width of the respective enhancement grid line 30 is larger than a width of the corresponding finger electrode 20. The larger wide enhancement grid line 30 is used for improving a contact area between the respective enhancement grid line 30 and the corresponding solder strip 40, thereby improving a welding area between the cell and the solder strip 40, improving the welding performance between the cell and the solder strip 40, and further improving the yield of the photovoltaic module and avoiding desoldering between the cell and the solder strip 40. Furthermore, the larger wide enhancement grid line 30 is used for improving a success rate of the alignment of overprinting between the respective finger electrode 20 and the respective enhancement grid line 30. The width of the respective enhancement grid line 30 is larger than the width of the corresponding finger electrode 20, which ensures the welding performance and the success rate of the alignment, reduces the amount of the paste of the finger electrodes 20 and the shielding area of the finger electrodes 20, and is beneficial to improving the cell efficiency.

In some embodiments, a length L4 of the respective enhancement grid line 30 satisfies 0.05mm ≤ L4 ≤ 1.5mm. The length L4 of the respective enhancement grid line 30 can ensure that the alignment between the solder strip 40 and the enhancement grid line 30 and ensure that a region of the cell in contact with the solder strip 40 is the enhancement grid line 30, thereby improving the contact area and the contact performance between the cell and the solder strip 40. The length of the respective enhancement grid line 30 should also not be too long, to avoid reducing the area of the cell to collect current and reducing the cell efficiency.

In some embodiments, in the extension direction X of the respective finger electrode 20, each side surface of the respective enhancement grid line 30 is in electrical contact with a part of a region of the respective finger electrode 20 other than the plurality of disconnection portions 21. In other words, the side surface of the respective enhancement grid line 30 is in electrical contact with a side surface of a corresponding first grid line 22. In some embodiments, one of upper and lower top surfaces of the respective enhancement grid line 30 is in electrical contact with the first grid line 22 in the extension direction of the respective finger electrode 20, thereby increasing the contact area between the first grid line 22 and the respective enhancement grid line 30, and reducing the misalignment during the overprinting process between the first grid line 22 and the enhancement grid line 30, and further improving the yield of the cells.

In some embodiments, the soler cell screen plate further includes auxiliary solder joints 31 located on both sides of each of the plurality of enhancement grid lines 30. A part of each auxiliary solder joint 31 is overlapped with and in electrical contact with another part of the region of the respective finger electrode 20 other than the plurality of disconnection portions 21. The respective auxiliary solder joint 31 and the respective enhancement grid line 30 are integrally formed, and the auxiliary solder joint 31 is also made of the printing pastes of the main busbars.

In some embodiments, the auxiliary solder joints 31 are used for improving the accuracy of alignment between the respective enhancement grid line 30 and the respective finger electrode 20, to avoid offset and misalignment between the respective finger electrode 20 and the respective enhancement grid line 30, thereby avoiding problems such as excessive contact resistance between the respective finger electrode 20 and the respective enhancement grid line 30 or breakage of the grid lines. The auxiliary solder joints 31 are further used for increasing the contact area between the respective enhancement grid line 30 and the respective finger electrode 20, thereby ensuring the connection performance between the respective enhancement grid line 30 and the respective finger electrode 20, such that the welding performance between the solder strip 40 and the cell can be ensured and desoldering between the solder strip 40 and the cell can be avoided.

In some embodiments, in the thickness direction of the respective finger electrode 20, the another part of the region of the respective finger electrode 20 other than the plurality of disconnection portions 21 is in electrical contact with a part of a top surface of a corresponding auxiliary solder joint 31. Alternatively, in the thickness direction of the respective finger electrode 20, the another part of the region of the respective finger electrode 20 other than the plurality of disconnection portions 21 is in electrical contact with a part of a bottom surface of a corresponding auxiliary solder joint 31. In the thickness direction of the respective finger electrode 20, each first grid line 22 is in electrical contact with the part of the top surface of the corresponding auxiliary solder joint 31. Alternatively, in the thickness direction of the respective finger electrode 20, the first grid line 22 is in electrical contact with the part of the bottom surface of the corresponding auxiliary solder joint 31. Compared with the manner in which the side surface of each first grid line 22 is in electrical contact with a side surface of the corresponding auxiliary solder joint 31 in the extension direction X of the respective finger electrode 20, in embodiments of the disclosure, the contact area between the respective auxiliary solder joint 31 and the respective first grid line 22 is increased, thereby reducing the contact resistance between the first grid line 22 and the auxiliary solder joint 31 and further improving the cell efficiency.

In some embodiments, a width of the respective auxiliary solder joint 31 is larger than a width of the respective finger electrode 20 in an arrangement direction Y of the finger electrodes 20. In addition, the width of the respective auxiliary solder joint 31 is larger than or equal to the width of the respective enhancement grid line 30. Since the width of each auxiliary solder joint 31 is large, when the auxiliary solder joints 31 are printed and then the finger electrodes 20 are overprinted, the relatively wider auxiliary solder joint 31 can ensure that the allowable offset range between each finger electrode 20 and the corresponding enhancement grid line 30 is relatively large, thereby improving the yield of the cells.

It is to be noted that the width of the respective auxiliary solder joint 31 is larger than the width of the respective finger electrode 20, but the width of the respective auxiliary solder joint 31 should not be too large, to reduce the shielding area of the solar cell and improve the cell efficiency.

In some embodiments, a side surface of the respective auxiliary solder joint 31 away from the corresponding enhancement grid line 30 in the arrangement direction Y of the finger electrodes 20 is a first width W1, and another side surface of the respective auxiliary solder joint 31 in contact with the corresponding enhancement grid line 30 has a second width W2, where the first width W1 is larger than the second width W2. Therefore, during overprinting of the finger electrodes, the respective auxiliary solder joint 31 of the larger first width W1 can ensure that the allowable offset between each finger electrode 20 and the corresponding enhancement grid line 30 is large, thereby improving the yield of the cells. In addition, a difference value between the first width W1 and the second width W2 enables the side surface of the respective auxiliary solder joint 31 in the arrangement direction Y of the finger electrodes 20 to be served as a guide groove, thereby reducing the shielding area of the respective auxiliary solder joint 31 and improving a success rate of alignment between the respective finger electrode 20 and the enhancement grid line 30.

In some embodiments, the first width W1 is in a range of 0.02mm to 1.5mm, i.e., 0.02mm ≤ W1 ≤ 1.5mm. The first width W1 may range from 0.02mm to 0.8mm, 0.18mm to 1.39mm, 0.2mm to 1.5mm, 0.9mm to 1.48mm, 0.5mm to 1mm, 0.6mm to 1.3mm, or 0.09mm to 0.8mm. The first width W1 may be 0.06mm, 0.58mm, 0.77mm, 0.98mm, 1.19mm, 1.28mm, 1.33mm, 1.42mm, or 1.5mm.

The second width W2 is in a range of 0.02mm to 2mm, i.e., 0.02mm ≤ W2 ≤ 2mm. The second width W2 may range from 0.02mm to 1.21mm, 0.18mm to 1.68mm, 0.2mm to 1.97mm, 0.9mm to 1.59mm, 0.5mm to 1.31mm, 0.6mm to 1.38mm, or 0.09mm to 0.94mm. The second width W2 may be 0.06mm, 0.78mm, 1.22mm, 1.58mm, 1.67mm, 1.78mm, 1.87mm, 1.92mm, or 2mm.

In some embodiments, the respective enhancement grid line 30 includes first portions 33 and a second portion 32 in the extension direction X of the respective finger electrode 20. Each first portion 33 is in contact with the corresponding first grid line 22, and the second portion 32 is in contact with the corresponding solder strip 40 or the corresponding main busbar 10. An end surface of each first portion 33 away from the second portion 32 has a third width W3 larger than a fourth width W4 of a contact surface of the first portion 33 in contact with the second portion 32. During overprinting of the finger electrodes 20, the first portion 33 with the larger third width W3 can ensure that the allowable offset range between each finger electrode 20 and the corresponding enhancement grid line 30 is relatively large, thereby improving the yield of the cells. In addition, a difference value between the third width W3 and the fourth width W4 enables the side surface of the first portion 33 in the arrangement direction Y of the finger electrodes 20 to be served as a guide groove, thereby reducing the shielding area of the respective enhancement grid line 30 and improving the success rate of alignment between the respective finger electrodes 20 and the respective enhancement grid line 30.

In some embodiments, the second portion 32 has a length L7 ranging from 0.01mm to 1.5mm, i.e., 0.01mm ≤ L7 ≤ 1.5mm. The length L7 may range from 0.01mm to 0.17mm, 0.18mm to 1.31mm, 0.23mm to 1.5mm, 0.88mm to 1.48mm, 0.5mm to 1.1mm, 0.6mm to 1.27mm, or 0.09mm to 0.92mm. The length L7 can be 0.01mm, 0.29mm, 0.38mm, 0.76mm, 1.02mm, 1.16mm, 1.29mm, 1.41mm, or 1.5mm.

In some embodiments, each first portion 33 has a length L8 ranging from 0.05mm to 1.5mm, i.e., 0.05mm≤L8≤1.5mm. The length L8 may range from 0.06mm to 0.17mm, 0.2mm to 1.38mm, 0.25mm to 1.48mm, 0.93mm to 1.42mm, 0.46mm to 1.12mm, 0.7mm to 1.8mm, or 0.14mm to 1.45mm. The length L8 can be 0.05mm, 0.28mm, 0.41mm, 0.86mm, 1.08mm, 1.14mm, 1.24mm, 1.43mm, or 1.5mm.

In some embodiments, the third width W3 has a range of 0.02mm to 1.5mm, i.e., 0.02mm ≤ W3 ≤ 1.5mm. The third width W3 may range from 0.02mm to 0.8mm, 0.18mm to 1.39mm, 0.2mm to 1.5mm, 0.9mm to 1.48mm, 0.5mm to 1mm, 0.6mm to 1.3mm, or 0.09mm to 0.8mm. The third width W3 may be 0.06mm, 0.58mm, 0.77mm, 0.98mm, 1.19mm, 1.28mm, 1.33mm, 1.42mm, or 1.5mm.

The fourth width W4 has a range of 0.02mm to 2mm, i.e., 0.02mm ≤ W4 ≤ 2mm. The fourth width W4 may range from 0.02mm to 1.21mm, 0.18mm to 1.68mm, 0.2mm to 1.97mm, 0.9mm to 1.59mm, 0.5mm to 1.31mm, 0.6mm to 1.38mm, or 0.09mm to 0.94mm. The fourth width W4 may be 0.06mm, 0.78mm, 1.22mm, 1.58mm, 1.67mm, 1.78mm, 1.87mm, 1.92mm, or 2mm.

In some embodiments, the solar cell screen plate further includes a passivation layer 101. The plurality of enhancement grid lines 30 are located on a surface of the passivation layer 101, and each respective finger electrode 20 is located on the surface of the passivation layer 101 and penetrates through a thickness of the passivation layer 101. The plurality of auxiliary solder joint 31 do not penetrate through the thickness of the passivation layer 101.

In some embodiments, the part of the respective auxiliary solder joint 31 overlapped with the another part of the region of the corresponding finger electrode 20 other than the plurality of disconnection portions 21 has a length of L6, 0.05mm ≤ L6 ≤1.5mm. That is, a length of an overlapping region between the respective auxiliary solder joint 31 and the first grid line 22 is L6, which is the same as L5 in FIG. 13. Since the respective enhancement grid line 30 is also in electrical contact with the respective first grid line 22, the length L5 shown in FIG. 13 is equal to the length L3 of the respective auxiliary solder joint 31 in the extension direction X of the respective finger electrode 20.

In some embodiments, in the extension direction of the respective finger electrode 20, a length L4 of the respective enhancement grid line 30 satisfies 0.02mm ≤ L4 ≤ 2mm. The length L4 may range from 0.02mm to 1.21mm, 0.18mm to 1.68mm, 0.2mm to 1.97mm, 0.9mm to 1.59mm, 0.5mm to 1.31mm, 0.6mm to 1.38mm, or 0.09mm to 0.94mm. The length L4 can be 0.06mm, 0.78mm, 1.22mm, 1.58mm, 1.67mm, 1.78mm, 1.87mm, 1.92mm, or 2mm.

In an alternative embodiment of the present disclosure, the solar cell includes a substrate 100; a passivation layer 101 positioned on a surface of the substrate 100; a plurality of finger electrodes 20 each including a plurality of disconnection portions 21 and a plurality of first grid lines 22; and a plurality of enhancement grid lines 30. Each first grid line 22 burns through a thickness of the passivation layer 101. Each respective enhancement grid line 30 is located at a respective disconnection portion 21. The respective enhancement grid line 30 is in electrical contact with corresponding first grid lines 22, and in electrical contact with a corresponding solder strip 40. The respective enhancement grid line 30 is located on the surface of the passivation layer 101 and does not burn through the passivation layer 101.

Referring to FIGS. 10 to 12, in an alternative embodiment of the disclosure, the solar cell is a square solar cell with a side length of D, where the side length D is in a range of 182mm to 220mm. In some embodiments, the side length of the solar cell may be in a range of 182mm to 190mm, 190mm to 200mm, 200mm to 210mm, or 210mm to 200mm.

In some embodiments, the number of the finger electrodes may be 100 to 200. The solar cell has a first surface and a second surface opposite to the first surface, and the number of finger electrodes of the second surface is greater than or equal to the number of finger electrodes of the first surface. For example, there are 156 finger electrodes on the first surface and 172 finger electrodes on the second surface.

In some embodiments, the side length D of the solar cell is equal to 182mm. The solar cell includes 132 finger electrodes 20 parallel to each other, and each two adjacent finger electrodes 20 are spaced apart from each other by 1.5mm.

It is to be noted that the number and spacing of the finger electrodes 20 in the drawings do not represent the actual number and spacing and are only used for illustration.

In some embodiments, the solar cell is a slice cell. In some embodiments, the slice cell is a half-piece cell, which can also be understood as a half-cut cell or a two-slice cell. In other embodiments, the slice cell may be a three-slice cell, a four-slice cell, an eight-slice cell, or the like.

Experimental Example 0: there is no enhancement grid line, that is, each finger electrode is a complete grid line.

Embodiment 1: a length of the respective enhancement grid line is equal to 1.3 times a width of the solder strip, and a width of the respective enhancement grid line is equal to a width of the respective finger electrode.

Embodiment 2: a length of the respective enhancement grid line is equal to 1.3 times a width of the solder strip, and a width of the respective enhancement grid line is equal to 1.3 times a width of the respective finger electrode.

Embodiment 3: a length of the respective enhancement grid line is equal to 1.5 times a width of the solder strip, and a width of the respective enhancement grid line is equal to 1.5 times a width of the respective finger electrode.

**Table 1**

| Group | Ratio of welding tensile force between respective solder strip and the cell to welding tensile force between respective solder strip and the cell in Example 0 | Cost ratio | Module yield |
|---|---|---|---|
| EXAMPLE 0 | 1 | 1 | 92.1% |
| Embodiment 1 | 110% | 94% | 95.9% |
| Embodiment 2 | 124% | 99% | 97.5% |
| Embodiment 3 | 140% | 105% | 98.3% |

According to the above table 1, providing the enhancement grid lines can increase the welding tension between the respective solder strip and the cell. The ratio of the welding tensile force of each embodiment to that of Example 0 shows that the larger area of the respective enhancement grid line contributes to the stronger welding tensile force when the solder strip is in contact with the cell. In addition, since each enhancement grid line is in electrical contact with corresponding finger electrodes and the corresponding solder strip, and the welding tensile force of the paste used for the enhancement grid lines is greater than that of the paste used for the finger electrodes, the arrangement of the enhancement grid lines can improve the welding tension of the solder strips a whole. In addition, since a preparation cost of the enhancement grid lines is lower than that of the finger electrodes, the cost of the paste used for the enhancement grid lines is lower, which can partially reduce the preparation cost of the photovoltaic module. With the increase of the use amount of the enhancement grid lines, although the cost may be increased, the welding tension may be effectively improved and the module yield may be improved.

According to the above embodiments, the solar cell screen plate and the solar cell provided in the embodiments of the disclosure achieve at least the following beneficial effects.

In the embodiments of the disclosure, the printing preparation process of the main busbars may be avoided by arranging the enhancement grid lines 30 in electrical contact with the solder strips 40 and arranging no main busbars in the cell. In addition, the shielding area caused by the main busbars can be avoided, thereby reducing optical loss and improving cell efficiency. Furthermore, false welding or offset caused by the alignment problem between the solder strip 40 and the main busbars can be avoided. Since the enhancement grid lines 30 and the solder strips 40 are intersected, the probability of the alignment between the enhancement grid lines 30 and the solder strips 40 is far greater than the probability of the alignment between the main busbars and the solder strips that are not intersected, thereby improving the yield of the photovoltaic module. Furthermore, each finger electrode 20 includes the plurality of disconnection portions 21, and each enhancement grid line 30 is located at a corresponding disconnection portion 21, so that false welding caused by the protrusion of the solder strip 40 at the junction of the solder strip 40 and the finger electrode 20 due to the height difference between the finger electrode 20 and the solder strip 40 can be avoided, and the paste consumption of the finger electrode 20 is also reduced, thus reducing the manufacturing cost. The printing paste of the respective enhancement grid line 30 is different from the printing paste of the respective finger electrode 20, so that the paste consumption of the finger electrodes 20 can be reduced, and the manufacturing cost can be reduced. Moreover, the height of the respective enhancement grid line 30 can be provided to be lower than the height of the respective finger electrode 20, which can be served as a basis for alignment of the solder strip 40, or can also be served as a groove for accommodating the solder strip 40, so as to improve the welding performance between the solder strip 40 and the cell.

FIG. 15 is a structural schematic diagram of a photovoltaic module provided in embodiments of the disclosure.

Accordingly, according to some embodiments of the present disclosure, yet another aspect of the embodiments of the disclosure further provides a photovoltaic module. Referring to FIG. 15, the photovoltaic module includes: a plurality of cell strings, each cell string being formed by connecting a plurality of solar cells 50 as in any of the above embodiments; and a plurality of solder strips 40 for connecting the solar cells 50; an encapsulation film 51 used for covering a surface of each of the at least one cell string and a surface of each of the solder strips 40; and a plurality of cover plates 52 each being used for covering a surface of a corresponding encapsulating film 51 facing away from the at least one cell string. The solar cells 50 are electrically connected in a monolithic or a plurality of pieces to form the plurality of cell strings, and the plurality of cell strings are electrically connected in series and/or in parallel.

Specifically, in some embodiments, the plurality of cell strings may be electrically connected with one another by the plurality of solder strips 40. FIG. 15 illustrates only a positional relationship between solar cells, i.e., electrodes of the cells having the same polarity are arranged in a same direction or electrodes of each cell having a positive polarity are arranged on a same side, so that conductive strips are connected to different sides of two adjacent cells, respectively. In some embodiments, the solar cells 50 may also be arranged in order that the electrodes of different polarities face the same side, that is, for the plurality of adjacent cells, the electrodes of the first polarity of each cell are interleaved with the electrodes of the second polarity of the adjacent cell, so that each conductive strip can connect two adjacent cells on the same side.

In some embodiments, no spacing is provided between the solar cells 50, i.e., the solar cells 50 overlap each other.

In some embodiments, each disconnection portion 21 is located at the intersection of the respective main busbar 10 and the respective finger electrode 20, the respective enhancement grid line 30 is in electrical contact with the respective main busbar 10, and each solder strip 40 is in electrical contact with the respective main busbar 10.

In some embodiments, each disconnection portion 21 is located at the intersection between the respective solder strip 40 and the respective finger electrode 20, and the respective solder strip 40 is in electrical contact with the respective enhancement grid line 30.

In some embodiments, the encapsulation film 51 include a first encapsulation layer covering one of front or back surfaces of the solar cell 50 and a second encapsulation layer covering the other of the front surface or back surface of the solar cell 50. Specifically, at least one of the first encapsulation layer or the second encapsulation layer may be an organic encapsulation film such as a Polyvinyl Butyral (PVB) film, an ethylene-vinyl acetate copolymer (EVA) film, a polyethylene octene coelastomer (POE) film, or a polyethylene terephthalate (PET) film. Alternatively, at least one of the first encapsulation layer or the second encapsulation layer may be a coextruded film such as, an EPE film formed by a layer of EVA, a layer of POE, and a layer of EVA, or an EP film formed by a layer of EVA and a layer of POE.

It shall be understood that the first encapsulation layer and the second encapsulation layer are distinguished from each other by a division line before lamination. After the lamination, there is no the first encapsulation layer and the second encapsulation layer included in the photovoltaic module because the first encapsulation layer and the second encapsulation layer consist an integral encapsulation film 51.

In some embodiments, each cover plate 52 may be a glass cover plate, a plastic cover plate or the like having a light transmission function. Specifically, a surface of the cover plate 52 facing the encapsulation film 51 may be a concave-convex surface, thereby increasing the utilization rate of incident light. The plurality of cover plates 52 include a first cover plate and a second cover plate, where the first cover plate faces the first encapsulation layer and the second cover plate faces the second encapsulation layer.

Although the present disclosure is disclosed as above with preferred embodiments, it is not intended to limit the claims. Any person skilled in the art can make several possible changes and modifications without departing from the concept of the present disclosure. Therefore, the scope of protection of the present disclosure shall be subject to the scope defined in the claims of the present disclosure. Furthermore, the embodiments of the specification and the drawings shown are illustrative only and are not the full scope of the claims of the disclosure.

While some specific embodiments of the present disclosure have been described in detail by way of example, it will be understood by those skilled in the art that the above examples are for illustration only and are not intended to limit the scope of the present disclosure.

Those of ordinary skill in the art should appreciate that the embodiments described above are specific embodiments of the disclosure, and in practical application, various changes may be made thereto in form and detail without departing from the scope of the disclosure. Any one of those skilled in the art may make their own changes and modifications without departing from the scope of the present disclosure. Therefore, the protection scope of the disclosure shall be subject to the scope defined in the claims.

## Claims

1. A solar cell screen plate, comprising:
16 parallel main busbars;
a plurality of parallel finger electrodes perpendicular to the 16 main busbars, wherein each respective finger electrode of the plurality of finger electrodes includes a plurality of disconnection portions, and each disconnection portion is defined at an intersection between a respective main busbar of the 16 main busbars and the respective finger electrode; and
a plurality of enhancement grid lines parallel to the plurality of finger electrodes, wherein each respective enhancement grid line is disposed at a respective disconnection portion, and the respective main busbar penetrates through the respective enhancement grid line.

2. The solar cell screen plate of claim 1, wherein the respective disconnection portion has a length of L1 in an extension direction of the respective finger electrode, wherein 0.3mm ≤ L1 ≤ 1.2mm.

3. The solar cell screen plate of claim 1, wherein the respective enhancement grid line has a length of L2 in an extension direction of the respective finger electrode, wherein 0.5mm ≤ L2 ≤ 1.5mm.

4. The solar cell screen plate of claim 1, wherein the respective enhancement grid line and the respective main busbar are printed integrally using a same paste.

5. The solar cell screen plate of claim 1, wherein the solar cell screen plate further includes auxiliary solder joints located on both sides of the plurality of enhancement grid lines.

6. The solar cell screen plate of claim 5, wherein each respective auxiliary solder joint of the auxiliary solder joints is a square auxiliary solder joint with a side length of L3, wherein 0.02mm ≤ L3 ≤ 0.04mm.

7. The solar cell screen plate of claim 1, wherein the solar cell screen plate further includes solder joints, and each respective solder joint is in a shape of an irregular pattern formed by a first triangle, a first rectangle, and a second triangle that are in communication with one another in an extension direction of the respective main busbar, and junctions between the first triangle, the first rectangle, and the second triangle are arc-shaped.

8. The solar cell screen plate of claim 7, wherein the respective solder joint has a height of H in a width direction of the respective main busbar, wherein 0.3mm ≤ H ≤ 0.5mm.

9. A solar cell screen plate, comprising:
a plurality of parallel finger electrodes, wherein each respective finger electrode of the plurality of finger electrodes includes a plurality of disconnection portions; and
a plurality of enhancement grid lines parallel to the plurality of finger electrodes, wherein each respective enhancement grid line is located at a respective disconnection portion, and the respective enhancement grid line has both ends being in electrical contact with a part of a region of the respective finger electrode other than the plurality of disconnection portions, and wherein the plurality of enhancement grid line are configured to be in electrical contact with a plurality of main busbars or in electrical contact with a plurality of solder strips, wherein
the respective enhancement grid line includes printing paste different from printing paste of the respective finger electrode.

10. The solar cell screen plate of claim 9, wherein the solar cell screen plate further includes a passivation layer, wherein the respective enhancement grid line does not penetrate through a thickness of the passivation layer, and the respective finger electrode is located on a surface of the passivation layer and penetrates through the thickness of the passivation layer.

11. The solar cell screen plate of claim 9, wherein
the respective enhancement grid line is in electrical contact with the part of the region of the respective finger electrode other than the plurality of disconnection portions at each side surface of the respective enhancement grid line in an extension direction of the respective finger electrode; or
the solar cell screen plate further includes auxiliary solder joints located on both sides of the plurality of enhancement grid lines, and a part of a respective auxiliary solder joint of the auxiliary solder joints is overlapped with and in electrical contact with another part of the region of the respective finger electrode other than the plurality of disconnection portions.

12. The solar cell screen plate of claim 11, wherein in a thickness direction of the respective finger electrode:
the another part of the region of the respective finger electrode other than the plurality of disconnection portions is in electrical contact with a part of a top surface of the respective auxiliary solder j oint; or
the another part of the region of the respective finger electrode other than the plurality of disconnection portions is in electrical contact with a part of a bottom surface of the respective auxiliary solder joint.

13. The solar cell screen plate of claim 11, wherein the respective auxiliary solder joint has a width larger than a width of the respective finger electrode in an arrangement direction of the plurality of finger electrodes.

14. The solar cell screen plate of claim 11, wherein the part of the respective auxiliary solder joint overlapped with the another part of the region of the respective finger electrode other than the plurality of disconnection portions has a length of L5, wherein 0.05mm ≤ L5 ≤1.5mm.

15. The solar cell screen plate of claim 9, wherein the respective enhancement grid line has a length of L in an extension direction of the respective finger electrode, wherein 0.05mm ≤ L ≤ 1.5mm.

16. A solar cell screen plate, comprising:
a plurality of parallel finger electrodes, wherein each respective finger electrode of the plurality of finger electrodes includes a plurality of disconnection portions; and
a plurality of enhancement grid lines parallel to the plurality of finger electrodes, wherein each respective enhancement grid line is located at a respective disconnection portion, and the respective enhancement grid line has both ends being in electrical contact with a part of a region of the respective finger electrode other than the plurality of disconnection portions, and wherein the plurality of enhancement grid lines are configured to be in electrical contact with a plurality of solder strips, wherein
the respective enhancement grid line includes printing paste different from printing paste of the respective finger electrode.

17. The solar cell screen plate of claim 16, wherein the respective enhancement grid line has a width larger than a width of the respective finger electrode in an arrangement direction of the plurality of finger electrodes.

18. The solar cell screen plate of claim 16, wherein
the respective enhancement grid line is in electrical contact with the part of the region of the respective finger electrode other than the plurality of disconnection portions at each side surface of the respective enhancement grid line in an extension direction of the respective finger electrode; or
the solar cell screen plate further includes auxiliary solder joints located on both sides of the plurality of enhancement grid lines, and a part of a respective auxiliary solder joint of the auxiliary solder joints is overlapped with and in electrical contact with another part of the region of the respective finger electrode other than the plurality of disconnection portions.

19. The solar cell screen plate of claim 18, wherein in a thickness direction of the respective finger electrode:
the another part of the region of the respective finger electrode other than the plurality of disconnection portions is in electrical contact with a part of a top surface of the respective auxiliary solder j oint; or
the another part of the region of the respective finger electrode other than the plurality of disconnection portions is in electrical contact with a part of a bottom surface of the respective auxiliary solder joint.

20. The solar cell screen plate of claim 19, wherein the respective auxiliary solder joint has a width larger than a width of the respective finger electrode, and larger than or equal to a width of the respective enhancement grid line, in an arrangement direction of the plurality of finger electrodes.

21. The solar cell screen plate of claim 20, wherein a side surface of the respective auxiliary solder joint away from the respective enhancement grid line in the arrangement direction of the finger electrodes has a first width, and another side surface of the respective auxiliary solder joint in contact with the respective enhancement grid line in the arrangement direction of the finger electrodes has a second width, wherein the first width is larger than the second width.

22. The solar cell screen plate of claim 21, wherein the first width W1 is in a range of greater than or equal to 0.02mm and less than or equal to 1.5mm.

23. The solar cell screen plate of claim 18, wherein the solar cell screen plate further includes a passivation layer, wherein
the respective enhancement grid line is positioned on a surface of the passivation layer, and the respective finger electrode is positioned on the surface of the passivation layer and penetrates through a thickness of the passivation layer; and
the respective auxiliary solder joint does not penetrate through the thickness of the passivation layer.

24. The solar cell screen plate of claim 18, wherein the part of the respective auxiliary solder joint overlapped with the another part of the region of the respective finger electrode other than the plurality of disconnection portions has a length of L6, wherein 0.05mm ≤ L6 ≤ 1.5mm.

25. The solar cell screen plate of claim 16, wherein the respective enhancement grid line has a length of L4 in an extension direction of the respective finger electrode, wherein 0.02mm ≤ L4 ≤ 1.5mm.

26. A solar cell, comprising the solar cell screen plate of any of claims 1 to 25.

27. The solar cell of claim 26, wherein the solar cell is a square solar cell with a side length of D, wherein D is equal to 182mm.

28. A photovoltaic module, comprising:
a plurality of cell strings, wherein each cell string is formed by connecting a plurality of solar cells, and each solar cell is the solar cell of claim 26 or 27;
a plurality of solder strips configured to connect the plurality of solar cells;
an encapsulation film configured to cover a surface of each of the plurality of cell strings and a surface of each of the plurality of solder strips; and
a plurality of cover plates, wherein each cover plate is configured to cover a surface of the encapsulation film away from the plurality of cell strings.

29. The photovoltaic module of claim 28, wherein the respective disconnection portion is defined at an intersection between a respective main busbar of the plurality of main busbars and the respective finger electrode, the respective enhancement grid line is in electrical contact with the respective main busbar, and the respective solder strip is in electrical contact with the respective main busbar.

30. The photovoltaic module of claim 28, wherein the respective disconnection portion is defined at an intersection between a respective solder strip of the plurality of solder strips and the respective finger electrode, and the respective solder strip is in electrical contact with the respective enhancement grid line.
